# EUROPÄISCHE PATENTANMELDUNG

(11) **EP 0 987 766 A1**
(43) Veröffentlichungstag der Anmeldung: **22.03.2000**
(21) Anmeldenummer: 99117160.4
(22) Anmeldetag: 01.09.1999
(51) Int. Cl.: H01L 29/78, H01L 29/739, H01L 29/06

(54) **Randstruktur für einen Feldeffekttransistor mit einer Vielzahl von Zellen**

(30) Priorität: 18.09.1998 US 156429
(71) Anmelder: SIEMENS AKTIENGESELLSCHAFT, 80333 München (DE)
(72) Erfinder: Deboy, Gerald, Dr., 80538 München (DE); Grassel, Helmut, Dr., 81827 München (DE); Stengl, Jens-Peer, 82284 Grafrath (DE)

(57) **Zusammenfassung**

Die Erfindung betrifft eine hochspannungsfeste Randstruktur für ein Halbleiterbauelement, bei dem eine Vielzahl von parallel geschalteten Einzelbauelementen (EB) in einer Vielzahl von Zellen (Z1,Z2,Z3) eines Zellenfeldes (ZF) angeordnet sind. Das erfindungsgemäße Halbleiterbauelement weist im Randbereich Zellen mit abgeschatteten Sourcezonenbereichen (9') auf. Diese abgeschatteten Sourcezonenbereiche (9') unterdrücken beim Abkommutieren des Leistungshalbleiterbauelementes das Einschalten eines parasitären Bipolartransistors (T1) verursacht durch die dortige überproportional große Rückstromdichte (I1). Darüber hinaus ist die Herstellung einer Randstruktur mit abgeschatteten Sourcezonenbereichen insbesondere bei selbstjustierenden Prozessen technologisch sehr einfach herstellbar und somit kostengünstig herstellbar. Der Halbleiterbauelement kann z.B. als vertikaler MOSFET oder IGBT ausgebildet sein.

## Beschreibung

Die Erfindung bezieht sich auf eine hochspannungsfeste Randstruktur für ein Halbleiterbauelement gemäß dem Oberbegriff des Patentanspruchs 1.

Derartige Halbleiterbauelemente können beispielsweise als MOSFETs ausgebildet sein, sofern die an die Innenzone angrenzende Drainzone denselben Leitungstyp wie die Innenzone aufweist. Zum anderen sind derartige durch Feldeffekt steuerbare Halbleiterbauelemente auch als IGBTs bekannt, sofern die Drainzone als Anodenzone mit entgegengesetztem Leitungstyp wie die Innenzone ausgebildet ist. In der US 5,008,725 ist ein solches Halbleiterbauelement beschrieben, bei dem eine Vielzahl von parallel geschalteten und jeweils in Zellen angeordneten Einzelbauelementen dicht gepackt in einem Zellenfeld angeordnet sind.

Im Freilaufbetrieb kommt es bei solchen Halbleiterbauelementen typischerweise zu einer Überschwemmung des Halbleitersubstrats mit Ladungsträgern beider Polaritäten. Diese Ladungsträger verteilen sich über die gesamte Innenzone, wobei die Ladungsträger insbesondere auch im Randbereich lateral über das aktive Zellenfeld hinaus diffundieren. Bei einem anschließenden Abkommutieren der Innenzone des Halbleiterbauelementes fließen die Ladungsträger des einen Leitungstypes unkritischerweise über die großflächige Drainmetallisierung an der Scheibenrückseite ab, während die Ladungsträger des jeweils anderen Leistungstypes über die jeweiligen Basiszonen und die Sourceelektrode an der Scheibenvorderseite abfließen. Insbesondere die im unmittelbaren Randbereich des Zellenfeldes angeordneten Zellen werden aufgrund der dortigen sehr großen Rückstromdichte besonders stark belastet und können - abhängig von der Kommutiersteilheit - schon bei relativ geringen Rückwärtsströmen in Folge des Einschaltens der bei einem solchen Halbleiterbauelement prinzipiell vorhandenen parasitären Bipolartransistoren zerstört werden.

Darüber hinaus treten diese unerwünschten Spannungsdurchbrüche speziell auch im Avalanche-Betrieb auf. Hier ist das elektrische Feld im Randbereich infolge der durch den Rand bedingten Krümmung der Dotierungsgebiete und somit dem unsymmetrischen Verlauf der Äquipotentiallinien besonders groß. Aufgrund der unsymmetrischen Feldverteilung im Randbereich können hier schon geringe Strömen zur Zerstörung des Halbleiterbauelementes führen.

Um solche unerwünschten Spannungsdurchbrüche zu vermeiden, werden bei gattungsgemäßen Halbleiterbauelementen im Randbereich außerhalb der aktiven Zellen ringförmige Dotierungsgebiete angeordnet. Solche Schutzringe, durch die lokale Feldstärkespitzen im Randbereich vermindert werden sollen, sind beispielsweise aus dem kanadischen Patent No. 667,423 bekannt. Die dort beschriebenen Schutzringe sind "floatend", d. h. sie weisen kein definiertes Potential auf. Solche floatenden Schutzringe müssen bekanntlich zum Rand hin sehr breit dimensioniert sein, da in diesen Schutzringen die elektrische Feldstärke auf nahezu "0" reduziert wird.

Darüber hinaus ist es auch möglich, die Schutzringe über Kontaktlöcher an die Sourcemetallisierung anzuschließen. In diesem Fall liegen diese "nicht-floatenden" Schutzringe auf demselben Potential wie die Sourcezone. Die Herstellung dieser floatenden und nicht-floatenden Schutzringe ist jedoch insbesondere bei einer selbstjustierenden Technologie äußerst aufwendig und somit sehr kostenintensiv. Die besondere Problematik bei der Herstellung der Schutzringe in einer selbstjustierenden Technologie liegt dabei insbesondere in der Vermeidung eines Kurzschlusses zwischen Sourceelektrode und Gateelektrode.

Solche Schutzringe werden typischerweise durch Ionenimplantation hergestellt. Bei der Ionenimplantation wird bekanntlich der Halbleiterkristall bzw. dessen Oberfläche derart stark gestört, daß dieser selbst bei einem anschließenden Ausheilschritt nicht optimal rekristallisiert. Bei dem anschließenden Aufwachsen des Gateoxids, an dessen Qualität besonders hohe Anforderungen gestellt sind, können Grenzflächenladungen an der Grenzfläche zum Halbleiterkörper bzw. bewegliche oder feste Ladungen im Gateoxid erzeugt werden. Diese parasitären Ladungen führen zu undefinierten Teilkapazitäten im Gateoxid, wodurch ein definiertes Schalten des Halbleiterbauelementes in diesem Bereich erschwert wird.

Ausgehend von diesem Stand der Technik liegt daher der vorliegenden Erfindung die Aufgabe zugrunde, eine hochspannungsfeste Bandstruktur für Halbleiterbauelemente anzugeben, die eine einfache und platzsparende Ausführung erlaubt und dennoch eine reproduzierbare, hohe Durchbruchspannung sicherstellt.

Erfindungsgemäß wird diese Aufgabe durch eine hochspannungsfeste Bandstruktur der eingangs genannten Art gelöst, bei der zumindest ein Teil der in einem Randbereich des Zellenfeldes angeordneten Sourcezonen abgeschattete Sourcezonenbereiche aufweisen, die dort bei einem Rückstrom von Ladungsträgern des ersten Leitungstypes das Einschalten einer parasitären Diode zwischen der jeweiligen Sourcezone und der Basiszone unterdrückt.

In der vorliegenden Erfindung wird der Halbleiterkörper zusätzlichen zu der Maskierung zur Herstellung der Sourcezonen durch eine weitere Lackmaske maskiert. Mit dieser zusätzlichen Lackmaske werden die Sourcezonen der im Randbereich gelegenen Zellen zumindest teilweise abgedeckt, wodurch diese abgedeckten Bereiche nicht oder nur schwach dotiert werden. Die aktive Zellenfläche des Halbleiterbauelementes wird durch diese Maßnahme zwar je nach Art der zusätzlichen Lackmaske um eine oder mehrere Zellreihen verringert, wodurch eine geringfügige Erhöhung des Einschaltwiderstandes R_{DSon} resultiert. Durch diese Maßnahme wird jedoch auf sehr einfache und platzsparende Weise das Einschalten von parasitären Bipolartransistaren im Randbereich verursacht durch Ladungsträgerrückströme beim Abkommutieren bzw. im Avalanchebetrieb unterdrückt.

Auf diese Weise wird gleichermaßen die Kommutierungsfestigkeit und die Avalanchefestigkeit, die beide sehr wichtige Robustheitskriterien für ein hochspannungsfestes Leistungshalbleiterbauelement darstellen, auf den maximal, von einer bestimmten Transistortechnologie erreichbaren Wert gesteigert.

Besonders vorteilhaft ist die vorliegende Erfindung bei Halbleiterbauelementen mit überwiegend selbstjustierenden Zellkonzepten, da die Justierung der zusätzlichen Maske aufgrund der sehr niedrigen Anforderungen an deren Justiergenauigkeit im Bereich der halben Gateeletrodenbreite völlig unkritisch ist. Darüberhinaus lassen sich die abgeschatteten Sourcezonenbereiche vorteilhafterweise in einem einzigen, gemeinsamen Prozeßschritt zusammen mit den Sourcezonen erzeugen. Schließlich sind die Waferprozeßkosten bei der Herstellung der abgeschatteten Sourcezonen im Vergleich zu der oben beschriebenen, äußerst aufwendigen Herstellung der Schutzringe mit Kontaktlochmetallisierung verschwindend gering.

Die abgeschatteten Sourcezonenbereiche sind typischerweise in denjenigen Bereichen der Sourcezonen angeordnet, in denen die Ausbildung eines stromführenden Kanals unterdrückt oder zumindest verringert werden soll. Typischerweise sind diese abgeschatteten Bereiche in den im Randbereich amgeordneten Zellen vorgesehen, und zwar vorzugsweise in den zum Rand hin gewandten Bereichen der jeweiligen Sourcezonen.

Das Zellenfeld eines typischen hochspannungsfesten Leistungshalbleiterbauelementes besteht aus einer Vielzahl von typischerweise uniformen, symmetrisch aufgebauten, dicht gepackten Zellen. Besonders vorteilhaft ist es, wenn die Zellen des Zellenfeldes eine hexagonale Querschnittsfläche aufweisen. Die hexagonale Struktur ermöglicht die dichteste Flächenpackung der Zellen, d. h. eine optimale Ausnutzung der Chipfläche. Außerdem wird bei der hexagonalen Zellenstruktur ein optimaler Durchlaßwiderstand bei gleichzeitig optimalem Laststorm erreicht. Weitere vorteilhafte Zellstrukturen ergeben sich bei Verwendung von etwa quadratischen Zellen bzw. rechteckigen, streifenförmigen oder dreieckigen Zellen. Die Erfindung ist jedoch auch bei anderen Zellanordnungen wie beispielsweise runden oder ovalen Zellen anwendbar.

Bei einem Zelldesign mit hexagonalen Zellen oder quadratischen Zellen ist es zur Unterdrückung eines parasitären Bipolartransistors im Randbereich des Zellenfeldes häufig notwendig, daß zumindest die beiden äußeren Zellreihen im Randbereich des Zellenfeldes abgeschattete Sourcezonenbereiche aufweisen. Der Anteil der abgeschatteten Sourcezonenbereiche innerhalb der jeweiligen Sourcezone einer Zelle ist dabei derart zu dimensionieren, daß sich eine optimale Unterdrückung des parasitären Bipolartransistors bei gleichzeitig optimalen Einschaltwiderstand ergibt. Typischerweise werden bei solchen Zelldesigns die Sourcezonen in der äußersten Zellreihe gänzlich abgeschattet. Bei den der äußersten Zellreihe nachfolgenden Zellreihen kann dann der Anteil der abgeschatteten Sourcezonenbereiche im Vergleich zur gesamten Sourcezone graduell verringert werden. In der Praxis reicht es häufig aus, wenn die äußerste Zellreihe gänzlich abgeschattet ist und die darauffolgende Zellreihe in der äußeren, dem Randbereich zugewandten Halbzellen abgeschattet ist.

Besonders vorteilhaft ist auch ein Zellendesign mit vorzugsweise streifenförmigen Zellen. Bei solchen Zellen ist es zumeist ausreichend, wenn im Randbereich des Zellenfeldes lediglich die äußerste Zellreihe abgeschattet ist. Die abgeschatteten Sourcezonenbereiche müssen dort lediglich in der äußersten, dem Randbereich zugewandten Halbzelle angeordnet sein.

In der bevorzugten Realisierung weisen die abgeschatteten Sourcezonenbereiche denselben Leitungstyp und dieselbe Dotierungskonzentration wie die jeweiligen Basiszonen auf. In diesem Fall lassen sich die abgeschatteten Sourcezonenbereiche auf sehr einfache Weise über eine zusätzliche Maskierung erzeugen.

Darüberhinaus ist es selbstverständlich auch denkbar, wenngleich auch technologisch aufwendiger, wenn die abgeschatteten Sourcezonenbereiche denselben Leitungstyp, jedoch eine niedrigere Dotierungskonzentration als die entsprechenden Sourcezonen aufweisen. Denkbar wären jedoch auch undotierte Abschattungabereiche in den Sourcezonen.

Besonders vorteilhaft ist es, wenn die Drainzone dieselbe Dotierung wie die Innenzone aufweist. Das daraus resultierende bevorzugte Halbleiterbauelement ist dann ein Leistungs-MOSFET. Die Erfindung ist jedoch auch auf IGBTs und andere Halbleiterbauelemente anwendbar. Im Falle der IGBTs ist dann die Drainzone als Anodenzone ausgebildet. Diese Anodenzone ist vom entgegengesetzten Leitungstyp wie die Innenzone und weist typischerweise eine sehr hohe Dotierungskonzentration auf. Darüber hinaus ist die Erfindung auf alle Arten von MOSFET, wie beispielsweise D-MOSFET, V-MOSFET, U-MOSFET, etc. anwendbar.

Bevorzugte Ausgestaltungen und Weiterbildungen der Erfindung sind Kennzeichen der Unteransprüche.

Die Erfindung wird nachfolgend anhand der in den Figuren der Zeichnung angegebenen Ausführungsbeispiele näher erläutert. Es zeigt dabei:
- Figur 1: einen Teilschnitt einer Randstruktur eines erfindungsgemäßen, hochspannungsfesten Halbleiterbauelementes, das hier als D-MOSFET (bzw. IGBT) ausgebildet ist;
- Figur 2: in einer Draufsicht das Layout eines hexagonal ausgebildeten Zellenfeld im Randbereich eines hochspannungsfesten Halbleiterbauelementes gemäß Figur 1, das erfindungsgemäße, abgeschattete Sourcezonenbereiche aufweist;
- Figur 3: in einer Draufsicht das Layout eines quadratischen Zellenfeldes im Randbereich eines hochspannungsfesten Halbleiterbauelementes;
- Figur 4: in einer Draufsicht das Layout eines streifenförmigen Zellenfeldes im Randbereich eines hochspannungsfesten Halbleiterbauelementes.

In allen Figuren der Zeichnung sind gleiche oder funktionsgleiche Elemente, sofern dies nicht anders angegeben ist, mit gleichen Bezugszeichen versehen.

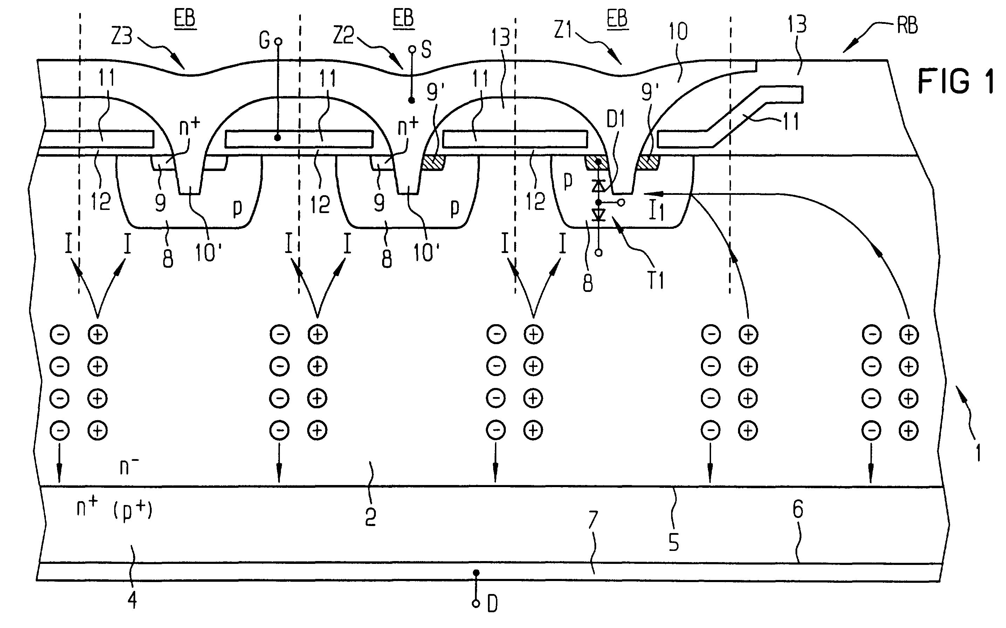

Figur 1 zeigt einen Teilschnitt einer Randstruktur eines erfindungsgemäßen, hochspannungsfesten (Leistungs-)Halbleiterbauelementes, das hier als D-MOSFET (bzw. IGBT) ausgebildet ist.

Das Halbleiterbauelementes weist eine Vielzahl von parallel geschalteten und jeweils in einzelnen Zellen angeordneten Einzelbauelementen EB auf. Der Teilschnitt in Figur 1 zeigt ausschnittsweise drei in einem Randbereich RB des Halbleiterbauelementes angeordnete Zellen Z1..Z3. Der Randbereich RB bezeichnet hier den Bereich des Halbleiterkörpers 1, der sich außerhalb der aktiven Zellen Z1...Z3 befindet. Das vertikal ausgebildete Halbleiterbauelement weist einen Sourceanschluß S, einen Gateanschluß G sowie einen Drainanschluß D auf, wobei der Sourceanschluß S und Drainanschluß D an gegenüberliegenden Seiten des Halbleiterkörpers 1 angeordnet sind.

In Figur 1 ist mit 1 der Halbleiterkörper des Halbleiterbauelementes bezeichnet. Der Halbleiterkörper 1, der beispielsweise aus Siliziumsubstrat besteht, weist eine im vorliegenden Ausführungsbeispiel schwach n-dotierte Innenzone 2 auf, die sourceseitig an die erste Oberfläche 3 des Halbleiterkörpers 1 angrenzt. Drainseitig grenzt eine Drainzone 4 an die Innenzone 2 an.

Ist das Halbleiterbauelement als MOSFET ausgebildet, dann ist die Drainzone 4 typischerweise stark n-dotiert. Ist das Halbleiterbauelement jedoch ein IGBT, dann wird die Drainzone 4 auch als Anodenzone bezeichnet und ist typischerweise stark p-dotiert (wie in Klammern angedeutet). In diesem Fall charakterisiert die Grenzfläche 5 den pn-Übergang zwischen Drainzone 4 und Innenzone 2. Darüber hinaus grenzt die Drainzone 4 an die zweite Oberfläche 6 des Halbleiterkörpers 1 an und ist hier großflächig an die Drainelektrode 7 und somit an den Drainanschluß D angeschlossen.

An der sourceseitigen Oberfläche 3 sind eine Vielzahl von Basiszonen 8 in die Innenzone 2 eingebettet. Die Basiszonen 8 weisen einen gegenüber der Innenzone 2 entgegengesetzten Leitungstyp auf, d. h. sie sind im gezeigten Fall p-dotiert. Im vorliegenden Ausführungsbeispiel ist in jeder der Basiszonen 8 jeweils eine einzige, stark n-dotierte Sourcezone 9 eingebettet. Es wäre auch denkbar, das jeweils mehrere Sourcezonen 9 in jeder der Basiszonen 8 vorgesehen sind.

Im vorliegenden Ausführungsbeispiel sind die Basiszonen 8 und die darin eingebetteten Sourcezonen 9 wannenförmig ausgebildet und können beispielsweise durch Ionenimplantation und/oder durch Diffusion erzeugt werden. Die Basiszonen 8 und/oder Sourcezonen 9 weisen typischerweise jedoch nicht notwendigerweise dieselbe Zellstruktur wie die entsprechenden Zellen Z1...Z3, in denen sie eingebettet sind, auf. Solche Zellstrukturen können streifenförmig, hexagonal, dreieckig, viereckig, rund, oval, etc. ausgebildet sein.

Das Halbleiterbauelement in Figur 1 ist als vertikaler D-MOSFET ausgebildet. Es wäre natürlich auch denkbar, daß die Sourcezonen 9 bzw. die Basiszonen 8 trenchförmig, V-grabenförmig oder ähnlich ausgebildet sind. Das entsprechende Halbleiterbauelement könnte dann als Trench-MOSFET bzw. als Trench-IGBTs ausbildet sein.

In Figur 1 sind die Sourcezonen 9 und die Basiszonen 8 in bekannter Weise über Kontaktlöcher 10' mit der Sourcelektrode 10 und damit mit dem Sourceanschluß S verbunden. Es wäre auch denkbar, daß die Basiszonen 8 nicht über diesen Nebenschluß mit der Sourceelektrode 10 kontaktiert ist. Jedoch wird durch den Nebenschluß der Basiszone 8 und der Sourcezone 9 vermieden, daß dort ein parasitärer Bipolartransistor eingeschaltet wird.

Darüber hinaus ist an der ersten Oberfläche 3 eine Gateelektrode 11 vorgesehen, die über ein dünnes Gateoxid 12 gegen den Halbleiterkörper 1 isoliert ist. Die Gateelektrode 11, die mit dem Gateanschluß G verbunden ist, kann beispielsweise aus hochdotiertem Polysilizium bzw. aus Metall bestehen. Ferner ist ein Feldoxid 13 vorgesehen, welches die Sourceelektrode 10 gegen die Gateelektrode 11 sowie gegen den Halbleiterkörper 1 isoliert.

Erfindungsgemäß sind in den im Randbereich RB angeordneten Zellen Z1..Z3 abgeschattete Sourcezonenbereiche 9' vorgesehen. Die abgeschatteten Sourcezonenbereiche 9' sind dabei als Bestandteil der Sourcezonen 9 innerhalb dieser Sourcezonen 9 angeordnet. Im Extremfall können die abgeschatteten Sourcezonenbereiche 9' auch den gesamten Bereich der entsprechenden Sourcezone 9 einnehmen. Die abgeschatteten Sourcezonenbereiche 9' weisen aus Technologiegründen typischerweise denselben Leitungstyp und dieselbe Dotierungskonzentration wie die Basiszonen 8 auf. Es wäre jedoch auch denkbar, wenngleich auch technologisch sehr aufwendig, daß die abgeschatteten Sourcezonenbereiche 9' denselben Leitungstyp wie die entsprechenden Sourcezonen 9, jedoch eine sehr viel niedrigere Dotierungskonzentration aufweisen. Vorstellbar wäre auch, wenn die abgeschatteten Sourcezonenbereiche 9' undotiert sind.

Wesentlich ist hierbei lediglich, daß durch die Anordnung der abgeschatteten Sourcezonenbereiche 9' innerhalb der Sourcezonen 9 im Randbereich RB des Zellenfeldes vermieden wird, daß durch einen Rückstrom I1 von Ladungsträgern, im vorliegenden Fall von Löchern, das unbeabsichtigte Einschalten der pn-Diode D1 somit das unbeabsichtigte Einschalten des parasitären Bipolartransistors T1 gebildet aus Sourcezone 9, Basiszone 8 und Innenzone 2 unterdrückt wird.

Im vorliegenden Ausführungsbeispiel weist die äußerste Zelle Z1 im Randbereich RB des Zellenfeldes eine komplett abgeschattete Sourcezone 9, 9' auf. Die nächst innere Zelle Z2 weist nur eine zur Hälfte abgeschattete Sourcezone 9, 9' auf und zwar die zum Rand hin gerichtete Halbzelle. Alle weiteren inneren Zellen Z3 weisen keine abgeschatteten Sourcezonenbereich 9' mehr auf.

Technologisch besonders attraktiv ist, daß für die Herstellung der abgeschatteten Sourcezonenbereiche 9' kein zusätzlicher Prozeßschritt notwendig ist, da diese abgeschatteten Sourcezonenbereiche 9' vorteilhafterweise zusammen mit den jeweiligen Sourcezonen 9 erzeugt werden können. Darüber hinaus erfordert die Maskierung der abgeschatteten Sourcezonenbereiche 9' keine aufwendige Technologie, da deren Justierung lediglich eine Lagegenauigkeit im Bereich der halben Gateelektrodenbreite aufweisen muß.

Nachfolgend wird anhand von Figur 1 die Funktionsweise der erfindungsgemäßen abgeschatteten Sourcezonenbereiche 9' im Randbereich RB des Halbleiterbauelementes näher erläutert.

Im Freilaufbetrieb eines Halbleiterbauelementes kommt es typischerweise zu einer Überschwemmung der Innenzone 2 mit Ladungsträgern. Im vorliegenden Fall eines n-Kanal-MOSFETs kommt es in der Innenzone 2 zu einer Überschwemmung mit positiven Ladungsträger (Löcher) und negativen Ladungsträger (Elektronen). Diese Ladungsträger verteilen sich in der gesamten Innenzone 2 sowohl in vertikaler als auch in lateraler Richtung in der Größenordnung der Diffusionslänge der jeweiligen Ladungsträger. Insbesondere im Randbereich RB des Halbleiterbauelementes verteilen sich diese Ladungsträger ebenfalls über den aktiven Zellbereich des Halbleiterbauelementes hinaus.

Bei einem anschließenden Kommutieren des Halbleiterbauelementes wird am Sourceanschluß S ein gegenüber dem Drainanschluß Dnegatives Potential angelegt. Dadurch fließen die Elektronen in der Innenzone 2 über die Drainzone 4 großflächig über die Scheibenrückseite 6 ab. Die Löchern fließen in entgegengesetzter Richtung über die Basiszone 8 zur Sourceelektrode 10. Dadurch resultiert ein im wesentlichen in vertikaler Richtung - und zwar in die Richtung der ersten Oberfläche 3 - gerichteter Löcherrückstrom I.

Im Randbereich RB des Halbleiterbauelementes, d. h. außerhalb des aktiven Zellenfeldes, resultieren die dort befindlichen Löcher ebenfalls zu einem Löcherstrom I1. Die Stomrichtung dieses Löcherstromes I1 weist dort aufgrund der fehlenden Sourcezonen 9 und Sourceelektroden 10 außerhalb des aktiven Zellenfeldes, die diesen Löcherstrom I1 absaugen könnten, zusätzlich eine horizontale Komponente auf. Aus der Gesamtmenge der außerhalb des aktiven Zellenfeldes befindlichen Löcher ergibt sich dann eine Löcherstromdichte J1, die sehr viel größer ist als die Löcherstromdichte J im Inneren des Halbleiterbauelementes. Der Betrag dieser Löcherrückstormdichte J1 im Randbereich RB des Halbleiterbauelementes ist insbesondere abhängig von der Diffuionslänge der Löcher.

Der Löcherrückstrom I1 wird typischerweise von den Sourceelektroden 10 der äußersten Zellen abgesaugt. Aufgrund des im wesentlichen horizontal verlaufenden Löcherrückstromes I1 im Randbereich RB des Halbleiterbauelementes kann es zu einem Spannungsabfall an der Diode D1 zwischen Basiszone 8 und Sourcezone 9 in den äußeren Zellen des Zellenfeldes kommen. Übersteigt dieser Spannungsabfall die Einschaltspannung der Diode D1, dann wird diese Diode D1 und somit auch der aus der Sourcezone 9, der Basiszone 8 und der Innenzone 2 resultierende parasitäre Bipolartransistor T1 eingeschaltet (sogenannter Latch-Effekt). Das Halbleiterbauelement schaltet unerwünschterweise durch. Das Halbleiterbauelement weist somit zumindest in diesem Randbereich RB eine niedrigere Spannungsfestigkeit auf.

Mittels der erfindungsgemäßen abgeschatteten Sourcezonenbereiche 9', die oberhalb des Strompfades des Löcherrückstromes I1 angeordnet sind, wird das Durchschalten dieser Diode D1 und damit des parasitären Transistors T1 unterbunden. Der gesamte Löcherrückstrom I1 kann so von den entsprechenden Sourceelektroden 10 abgesaugt werden, wodurch die Spannungsfestigkeit des gesamten Halbleiterbauelementes auch im Randbereich RB erhalten bleibt. Auf diese Weise kann die Robustheit des Halbleiterbauelementes vollständig ausgeschöpft werden.

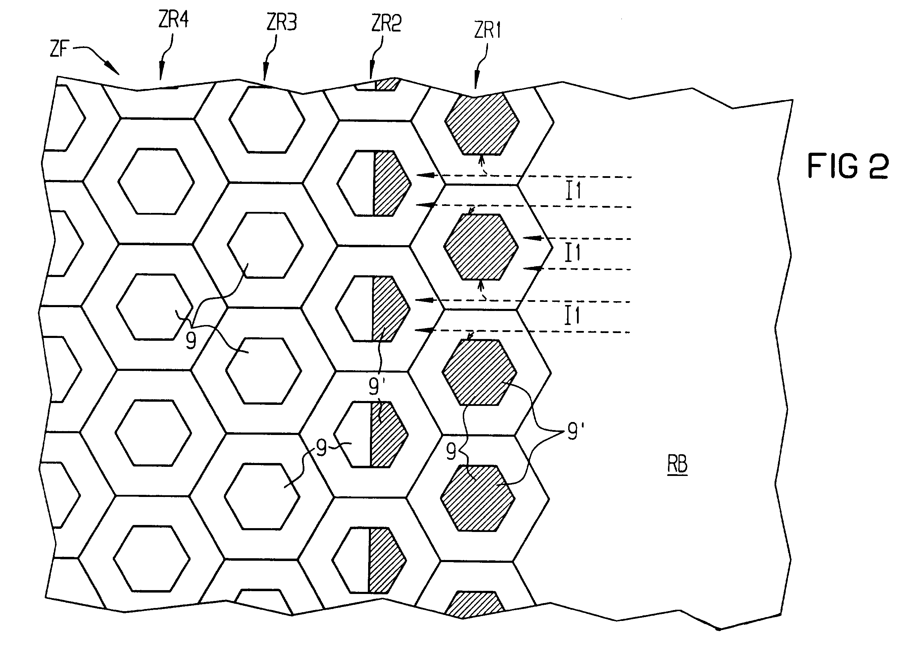

Figur 2 zeigt in einer Draufsicht ausschnittsweise das Layout eines hexagonal ausgebildeten Zellenfeld im Randbereich RB eines hochspannungsfesten Halbleiterbauelementes gemäß Figur 1, das erfindungsgemäße, abgeschattete Sourcezonenbereiche 9' aufweist. In der Draufsicht in Figur 2 wurden lediglich die einzelnen Zellen des Zellenfeldes mit den darin angeordneten Sourcezonen 9 sowie die Löcherströme I1 im Randbereich RB skizziert. Auf die Darstellung der Basiszonen 8 sowie der Elektroden wurde aus Gründen der besseren Übersicht verzichtet.

Das mit ZF bezeichnete Zellenfeld weist ein hexagonales Zellendesign mit einer Vielzahl von hexagonal ausgebildeten Zellen, von denen ausschnittsweise die vier äußeren Zellreihen ZR1...ZR4 dargestellt wurden, auf. Die äußerste Zellereihe ist hier mit ZR1 bezeichnet. Die nach innen folgenden Zellreihen ZR2...ZR4 weisen eine dazu aufsteigende Indizierung auf. Die Verwendung von hexagonalen Zellen erweist sich wie eingangs erwähnt als besonders vorteilhaft, da diese gegenüber anderen Zellstrukturen, wie beispielsweise dreieckigen oder quadratischen Zellen, in der Fläche eine höhere Parkettierung bzw. eine optimale Flächenpackung aufweisen.

Entsprechend dem Teilschnitt in Figur 2 sind die Sourcezonen 9 in den Zellen der äußersten Zellreihe ZR1 komplett abgeschattet. Die Sourcezonen 9 der Zellen der zweitäußersten Zellreihe ZR2 weisen hingegen nur zum Teil abgeschattete Sourcezonen 9' auf. Im vorliegenden Ausführungsbeispiel sind hier jeweils die Sourcezonenbereiche 9' der nach außen gerichteten Halbzellen abgeschattet.

Der Anteil der abgeschattenden Sourcezonenbereiche 9' innerhalb der jeweiligen Sourcezonen 9 ist je nach Applikation geeignet zu wählen und hängt insbesondere von der Rückstromdichte im Randbereich RB ab. Typischerweise ist es bei einem hexagonal ausgebildeten Zellendesign vollkommen ausreichend, lediglich zwei Zellreihen ZR1, ZR2 entsprechend dem Ausführungsbeispiel in Figur 2 mit abgeschatteten Sourcezonenbereichen 9' zu versehen. Es wäre selbstverständlich auch denkbar, daß lediglich eine einzige Zellreihe ZR1 bzw. mehr als zwei Zellreihen ZR1..ZR4 abgeschatteten Sourcezonenbereichen 9' aufweisen.

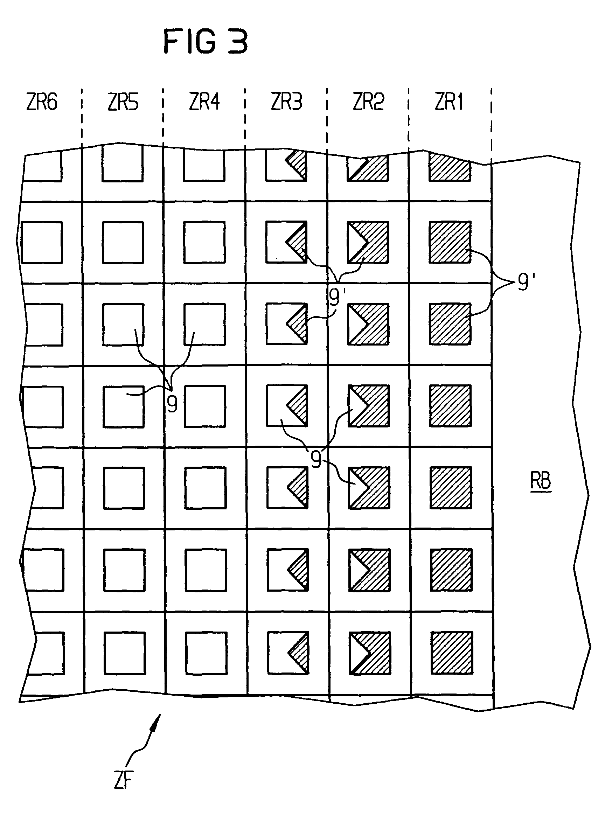

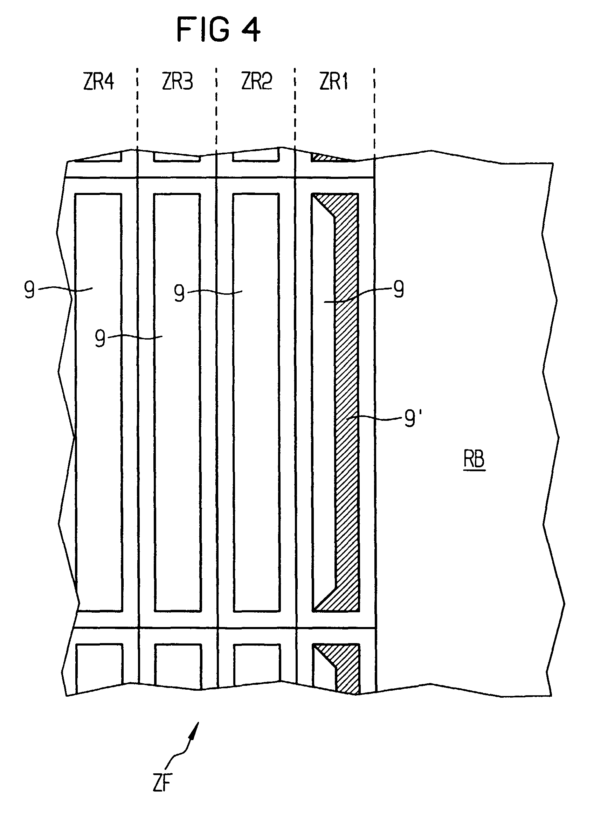

Das Ausführungsbeispiel gemäß der Figuren 1 und 2 beschreibt jeweils ein hexagonal ausgebildetes Zellenlayout, das insbesondere geometrisch besonders vorteilhaft ist. Die Erfindung ist selbstverständlich nicht ausschließlich auf ein hexagonales Zellenfeldlayout beschränkt, sondern kann auch sehr vorteilhaft auf ein Zellenfeldlayout mit quadratischen (Figur 3), dreieckigen, rechteckigen, streifenförmigen (Figur 4), etc. Zellen übertragen werden. Denkbar wäre auch ein Zellenlayout mit runden oder ovalen Zellen.

Bei einem Zellenfeld mit quadratischen Zellen ist es je nach Design erforderlich, mehr als zwei Zellreihen mit abgeschattete Sourcezonenbereichen 9' ausbilden. Im Ausführungsbeispiel gemäß Figur 3 weisen die äußeren drei Zellreihen ZR1...ZR3 im Randbereich RB des Halbleiterbauelementes abgeschattete Sourcezonenbereiche auf, wobei der Anteil der abgeschatteten Sourcezonenbereiche 9' an den jeweiligen Sourcezonen 9 zum Rand hin graduell zunimmt. Die weiteren inneren Zellreihen ZR4...ZR6 weisen dann keine abgeschatteten Sourcezonenbereiche 9 auf.

Figur 4 zeigt in einer Draufsicht ein streifenförmiges Zellendesign. Bei diesem Ausführungsbeispiel ist lediglich die äußerste Zelle bzw. Zellreihe ZR1 mit einem abgeschatteten Sourcezonenbereich 9' versehen, wobei der abgeschattete Sourcezonenbereich 9' dort lediglich in der dem Rand zugewandten Halbzelle angeordnet ist. Bei einem streifenförmigen Zellendesigns ist dies vollkommen ausreichend, da der vom Randbereich RB außerhalb des aktiven Zellenfeldes kommende Rückstrom bereits komplett durch die Sourceelektrode 10 der äußersten Zellreihe ZR1 abgesaugt wird.

### Bezugszeichenliste

- 1: Halbleiterkörper
- 2: Innenzone
- 3: erste Oberfläche
- 4: Drainzone
- 5: Grenzfläche, pn-Übergang
- 6: zweite Oberfläche
- 7: Drainelektrode
- 8: Basiszone
- 9: Sourcezone
- 9': abgeschattete Sourcezonenbereiche
- 10: Sourceelektrode
- 10': Kontaktloch für die Sourceelektrode
- 11: Gateelektrode
- 12: Gateoxid
- 13: Feldoxid
- D: Drainanschluß
- S: Sourceanschluß
- G: Gateanschluß
- D1: parasitäre Diode
- EB: Einzelbauelement
- I: Rückstrom innerhalb des aktiven Zellenfeldes
- I1: Rückstrom außerhalb des aktiven Zellenfeldes
- RB: Randbereich des Halbleiterbauelementes
- T1: parasitärer Transistor
- Z1 - Z3: Zellen im Zellenfeld
- ZF: Zellenfeld
- ZR1 - ZR6: Zellreihen

## Patentansprüche

1. Hochspannungsfeste Randstruktur für ein Halbleiterbauelement, bei dem eine Vielzahl von parallel geschalteten Einzelbauelementen (EB) in einer Vielzahl von Zellen (Z1...Z3) eines Zellenfeldes (ZF) angeordnet sind,
• mit einem Halbleiterkörper (1),
• mit mindestens einer im Halbleiterkörper (1) angeordneten Innenzone (2) vom ersten Leitungstyp, die mindestens teilweise an eine erste Oberfläche (3) des Halbleiterkörpers (1) angrenzt,
• mit mindestens einer Drainzone (4), die an die Innenzone (2) angrenzt,
• mit mindestens einer Basiszone (8) vom zweiten Leitungstyp, die an der ersten Oberfläche (3) in den Halbleiterkörper (1) eingebettet ist,
• mit mindestens einer Sourcezone (9) vom ersten Leitungstyp, die jeweils in eine der Basiszonen (8) eingebettet ist,
**dadurch gekennzeichnet,** daß
zumindest ein Teil der in einem Randbereich (RB) des Zellenfeldes (ZF) angeordneten Sourcezonen (9) abgeschattete Sourcezonenbereiche (9') aufweist, die dort bei einem Rückstrom (I1) von Ladungsträgern das Einschalten einer parasitären Diode (D1) zwischen der jeweiligen Sourcezone (9) und der Besiszone (8) unterdrückt.

2. Randstruktur nach Anspruch 1,
**dadurch gekennzeichnet,** daß
das Zellenfeld (ZF) hexagonale Zellen (Z1...Z3) aufweist.

3. Randstruktur nach Anspruch 1,
**dadurch gekennzeichnet,** daß
das Zellenfeld (ZF) quadratische Zellen (Z1...Z3) aufweist.

4. Randstruktur nach einem der Ansprüche 2 oder 3,
**dadurch gekennzeichnet,** daß
im Randbereich (RB) des Zellenfeldes (ZF) zumindest die beiden äußersten Zellreihen (ZR1, ZR2) abgeschattete Sourcezonenbereiche (9') aufweisen.

5. Randstruktur nach einem der Ansprüche 2 bis 4,
**dadurch gekennzeichnet,** daß
im Randbereich (RB) des Zellenfeldes (ZF) die äußerste Zellreihe (Z1) Sourcezonen (9) aufweist, die gänzlich durch die Sourcezonenbereiche (9') abgeschattet sind.

6. Randstruktur nach Anspruch 1,
**dadurch gekennzeichnet,** daß
das Zellenfeld (ZF) streifenförmige Zellen aufweist.

7. Randstruktur nach Anspruch 6,
**dadurch gekennzeichnet,** daß
im Randbereich (RB) des Zellenfeldes (ZF) nur die äußerste Zellreihe (ZR1) abgeschattete Sourcezonenbereiche (9') aufweist, die dort in der zum Rand hin gerichtete Hälfte der jeweiligen Zelle angeordnet ist.

8. Randstruktur nach einem der vorhergehenden Ansprüche,
**dadurch gekennzeichnet,** daß
die abgeschatteten Sourcezonenbereiche (9') denselben Leitungstyp und dieselbe Dotierungskonzentration wie die jeweiligen Basiszonen (8) aufweisen.

9. Randstruktur nach einem der Ansprüche 1 bis 7,
**dadurch gekennzeichnet,** daß
die abgeschatteten Sourcezonenbereiche (9') denselben Leitungstyp und eine niedrigere Dotierungskonzentration wie die jeweiligen Sourcezonen (9) aufweisen.

10. Randstruktur nach einem der vorhergehenden Ansprüche,
**dadurch gekennzeichnet,** daß
das Halbleiterbauelement ein vertikaler Leistungstransistor oder ein IGBT ist.
